Europäisches Patentamt

European Patent Office

Office européen des brevets

(19)

(11) Veröffentlichungsnummer : **0 078 935**
**B1**

(12) **EUROPÄISCHE PATENTSCHRIFT**

(45) Veröffentlichungstag der Patentschrift :
11.01.89

(21) Anmeldenummer : 82109533.8

(22) Anmeldetag : 15.10.82

(51) Int. Cl.⁴ : **H 01 G   4/20**, H 01 G   4/38,
**H 05 K   1/16**, H 03 K 17/975

(54) **Dickschichtkondensator in Druckschaltungstechnik.**

(30) Priorität : 05.11.81 DE 3143995

(43) Veröffentlichungstag der Anmeldung :
18.05.83 Patentblatt 83/20

(45) Bekanntmachung des Hinweises auf die Patenterteilung : 11.01.89 Patentblatt 89/02

(84) Benannte Vertragsstaaten :
FR GB IT NL

(56) Entgegenhaltungen :
DE—A— 2 434 390
FR—A— 1 051 606
21st ELECTRONIC COMPONENTS CONFERENCE,
10.-12. Mai 1971, Washington, D.C., Seiten 343-345;
R.T. JACOBSEN: "Loaded polymer film capacitors"
CHEMICAL ABSTRACTS, Band 79, Nr. 8, 27. August
1973, Seite 311, Nr. 47101e, Columbus, Ohio, US; &
DD - A - 94 423 (W.E. FIEDLER u.a.) 12.12.1971

(73) Patentinhaber : PREH, Elektrofeinmechanische
Werke Jakob Preh Nachf. GmbH & Co.
Postfach 1740 Schweinfurter Strasse 5
D-8740 Bad Neustadt/Saale (DE)

(72) Erfinder : Westermeir, Gisela, Ing. grad.
Rhönblick 31
D-8741 Hohenroth (DE)
Erfinder : Fehr, Friedhard
Wengertstrasse 9
D-8731 Lauter (DE)

EP 0 078 935 B1

Jouve, 18, rue St-Denis, 75001 Paris, France

## Beschreibung

Die Erfindung betrifft einen Dickschichtkondensator für ein in Druckschaltungstechnik hergestelltes kapazitives Tastenaggregat nach dem Oberbegriff des Anspruches 1, derartige Kondensatoren und Anschluß- und Verbindungsleitungen der Kondensatoren enthaltende gedruckte Schaltungen, sowie Herstellungsverfahren hierfür.

Es besteht seit längerem ein Bedürfnis nach in einfacher und billiger Weise herstellbaren Kondensatoren, insbesondere zur Einbeziehung in gedruckte Schaltungen. In jüngster Zeit ist in dieser Hinsicht ein vermehrtes Bedürfnis durch die Verwendung kapazitiver Eingabetastaturen für Datenverarbeitungsanlagen entstanden. Die DE-OS 2 744 206 betrifft eine für ein derartiges Tastenfeld vorgesehene kapazitive Taste, wobei der Kondensator als solcher jedoch in herkömmlicher Weise aus zudem gegeneinander beweglichen mechanischen Teilen aufgebaut ist.

Es ist bereits bekannt, Kondensatoren unter mehr oder weniger weitgehender Anwendung von Druckschaltungstechniken herzustellen. Aus der DE-OS 2 841 742 ist ein kapazitives Netzwerk, insbesondere zur Verwendung als Kondensatorkaskadenanordnung in Spannungsvervielfachern bekannt, bei welchem jeweils auf einer das Kondensator-Dielektrikum bildenden Grundplatte Metallschichten aufgedruckt sind, welche als Kondensatorbeläge und Anschlüsse dienen. Durch Übereinanderstapelung derartiger Dielektrikumsplatten mit aufgedruckten Metallschichten und Metallisierungen zur geeigneten Verbindung der einzelnen Schichten miteinander erhält man eine Stapelanordnung von beispielsweise in Parallel- oder in Serienschaltung liegenden Kondensatoren. Diese bekannte Bauart, welche also von vorgegebenen Dielektrikumsplatten als Kondensator-Dielektrikum ausgeht, ist zur Einbeziehung in gedruckte Schaltungen, in welchen ja auf einer Substrat- oder Trägerplatte alle elektrisch-funktionellen Teile im wesentlichen durch Beschichtungen erzeugt werden sollen, wenig geeignet. Ähnliches gilt für bekannte Kondensatorausführungen, bei welchen Metallplättchen als Kondensatorbeläge verwendet werden, was sich ebenfalls nicht gut zur Integration in die im wesentlichen nur mit Bedruckungs- oder Ätzschritten arbeitende Technologie der gedruckten Schaltung eignet.

Die FR-A-1 051 606 beschreibt die Erzeugung eines dielektrischen Stoffes wobei Puder aus keramischem, dielektrischen Stoff in ein dielektrisches Bindemittel eingearbeitet ist. Als Bindemittel sind unter anderem Polymere vorgeschlagen, die unterhalb 250 °C aushärtbar und mittels z. B. Pinsel oder Spritzpistole verarbeitbar sind.

Aus der DE-OS 2 132 935 ist bereits ein im Siebdruckverfahren herstellbarer Kondensator bekannt, zu dessen Herstellung auf einer Trägerplatte eine Silberpaste als Kondensatorgrundelektrode aufgedruckt und unter Verflüchtigung des Trägermittels eingebrannt wird, sodann wird hierauf eine siebdruckfähige Dielektrikumspaste, welche eine Glas- oder Keramikfritte in einem organischen Trägermittel, beispielsweise einer Äthylzelluloselösung in Terpineol enthält, als Dickschicht-Dielektrikum aufgetragen und sodann bei Temperaturen zwischen 800 °C und 1 000 °C eingebrannt. Auf das Dielektrikum kann als Kondensatorgegenelektrode wiederum eine Silberpaste aufgetragen werden, die bei einer Temperatur unter 780 °C eingebrannt wird.

Diese bekannte Ausführung eines Dickschicht-Kondensators hat den Nachteil, daß sie wegen der hohen Einbrenntemperatur um ca. 1 000 °C auf feuerfeste Trägermaterialien wie beispielsweise $Al_2O_3$ beschränkt ist. Dies wiederum hat Einschränkungen hinsichtlich der verfügbaren Abmessungen zur Folge, da derartige feuerfeste Trägerplatten beispielsweise aus $Al_2O_3$ nicht in den für großflächige Eingabetastaturen mit einer relativ hohen Anzahl von Kondensatoren und zugeordneten Anschluß- und Verbindungsleitungen erforderlichen großen Flächenabmessungen planar zu halten und außerdem prohibitiv teuer sind. Die Verwendung von durch Aufdrucken und Einbrennen von Silberpasten hergestellten Kondensator-Elektroden hat die Nachteile, daß die Gefahr von Silberwanderungen während der Einbrennvorgänge und/oder im späteren Betriebszustand besteht, und daß derartige Silberpasten-Metallisierungen außerdem nicht ohne weiteres lötfähig sind.

Durch die Erfindung soll daher ein in Druckschaltungstechnik hergestellter Dickschicht-Kondensator geschaffen werden, für dessen Herstellung keine hohen Einbrenntemperaturen in der Größenordnung von 1 000 °C erforderlich sind und der sich zur weitgehenden Integration in die Herstellung gedruckter Schaltungen eignet. Insbesondere soll durch die Erfindung die Anwendung derartiger Kondensatoren für die Druckschaltungstechnik in größerer Anzahl auf entsprechend großflächigen Trägerplatten ermöglicht werden, wie dies beispielsweise für kapazitive Eingabetastaturen von Datenverarbeitungsanlagen erforderlich ist. Der Kondensator bzw. eine mehrere derartige Kondensatoren mit zugehörigen Leitungsverbindungen enthaltende gedruckte Schaltung soll praktisch ausschließlich mittels Siebdruck-Beschichtungsvorgängen (ggf. unter Einbeziehung selektiver Ätzverfahren) herstellbar sein und die Kondensatorbeläge sowie Leitungsanschlüsse sollen vorzugsweise als kostengünstigere und zudem unmittelbar lötfähige Kupfer- oder Nickelmetallisierungen ausführbar sein.

Die Erfindung betrifft somit einen Dickschichtkondensator für ein in Druckschaltungstechnik hergestelltes kapazitives Tastenaggregat für Eingabeinstrumente von Datenverarbeitungsanlagen, mit einer auf einer Substrat- oder Trägerplatte vorgesehenen Grundelektrode, einem auf diese siebgedruckten, polymeren Dickschicht-Dielektrikum und einer über diesem in Ausrichtung mit der Grundelektrode vorgesehenen Gegenelektrode.

Zur Lösung der Erfindungsaufgabe ist gemäß der Erfindung vorgesehen, daß die Kondensatorgrundelektroden und gegebenenfalls zugeordnete Leitungsanschlüsse auf aktivierten Siebdruckschichten stromlos abgeschiedene Metallisierungen oder subtraktiv aus kaschiertem Substratmaterial erzeugte Metallflächen sind, daß das Dielektrikum aus einer im Siebdruck aufgebrachten, ausgehärteten Dispersion dielektrischer Füllstoffe in einem Polymermaterial mit relativ niedriger Aushärtetemperatur im Bereich von 150 °C bis 230 °C besteht, und daß die Gegenelektrode und ggf. zugeordneten Leitungsanschlüsse stromlos abgeschiedene Metallisierungen auf einer zweiten, für stromlose Metallisierung aktivierten, katalysatorgefüllten Dielektrikumsschicht sind, die über dem ersten Dickschicht-Dielektrikum angeordnet ist.

Vorzugsweise kann das Dickschicht-Dielektrikum aus einer 70 bis 90 Gew.-% dielektrische Füllstoffe und 30 bis 10 Gew.-% Polymermaterial enthaltenden Dispersion bestehen. Als Polymermaterial kann es ein oder mehrere Polymerharz(e) aus der Gruppe Polyurethan, Polyester-, Epoxy-, Melaminformaldehydharz enthalten, als dielektrische Füllstoffe einen oder mehrere Stoff(e) aus der Gruppe ZnO, $Al_2O_3$, $SrTiO_3$, $BaTiO_3$ oder Keramiksubstanzen.

Indem nach einem Grundgedanken der Erfindung das Kondensator-Dielektrikum aus einer siebdruckfähigen Dickschichtpaste auf der Basis eines bei relativ niedrigen Temperaturen aushärtbaren Polymermaterials erzeugt wird, kann auf hohe Einbrenntemperaturen in der Größenordnung von 1 000 °C verzichtet werden ; die angegebenen Polymerharze für die Zwecke der Erfindung sind bei Temperaturen oberhalb 130 °C, vorzugsweise im Bereich zwischen etwa 150 und etwa 230 °C aushärtbar. Hierdurch wird es möglich, als Substratmaterial normales Hartpapier, Kunststoffe und Folien der für gedruckte Schaltungen üblichen Art zu verwenden, im Gegensatz zu den Keramiksubstraten, wie sie für die mit Glas- und Keramikfritten als Dielektrikum hergestellten Dickschicht-Kondensatoren etwa nach der DE-OS 2 132 935 erforderlich waren. Hierdurch wird auch die Herstellung verhältnismäßig großflächiger gedruckter Schaltungen mit derartigen Kondensatoren ermöglicht, insbesondere in Ausbildung als kapazitives Tastenaggregat zur Eingabeinstrumente von Datenverarbeitungsanlagen. Die erfindungsgemäß als Bindemittel für das Dickschicht-Dielektrikum verwendeten Polymerharze sind auch billiger als die für das bekannte Dickschicht-Dielektrikum mit Glas- oder Keramikfritten erforderlichen Bindemittel, außerdem werden durch die Aushärtbarkeit bei größenordnungsmäßig niedrigeren Temperaturen erhebliche Energieeinsparungen erreicht und Degradationen anderer Schaltungsteile, wie sie bei Einbrenntemperaturen in der Größenordnung von 1 000 °C unvermeidlich sind und die Integration derartiger Kondensatoren in gedruckte Schaltungen behindern würden, werden zuverlässig vermieden.

Die Herstellung der unteren oder Kondensatorgrundelektroden und ggf. zugeordneten Leiterbahnen könnte in an sich bekannter Weise etwa in subtraktiver Technik durch selektive Ätzung einer Metallkaschierung des Substratmaterials erfolgen oder durch entsprechende direkte Bedruckung mit Leiterpasten, insbesondere Silber- oder Goldpasten im gewünschten Lay-out. Gemäß dem Erfindungsgedanken ist jedoch vorteilhaft vorgesehen, daß die Kondensatorgrundelektrode(n) und ggf. zugeordnete Leiterbahnen stromlos abgeschiedene Metallisierungen auf für stromlose Metallisierung aktivierten. Siebdruckschichten sind, wobei die Metallisierung vorzugsweise aus Kupfer, ggf. auch aus Nickel bestehen kann. Diese durch stromlose Abscheidung auf entsprechend aktivierten Unterlageschichten erzeugten Metallisierungen sind voll lötbar und können beispielsweise mit Chipbauteilen direkt verbunden werden. Die so erhaltenen Metallschichten (Kondensatorelektroden und/oder Leiterbahnen) weisen ferner eine hohe Haftfestigkeit an ihren Unterlagen auf und sind zudem preisgünstiger als die durch Aufdrucken von Pd, Ag oder Au Cermetpasten erzeugten Elektroden bzw. Leitungen.

Entsprechend können gemäß einer bevorzugten Ausgestaltung auch die oberen oder Kondensatorgegenelektroden und ggf. zugeordneten Leiterbahnen als stromlos abgeschiedene Metallisierungen auf einer zweiten, für stromlose Metallisierung· aktivierten Dielektrikumsschicht über dem ersten Dickschicht-Dielektrikum ausgeführt sein. Hierzu ist gemäß einer bevorzugten Ausgestaltung der Erfindung vorgesehen sein, daß auf die erste Dielektrikumsschicht nach deren Aushärtung im Siebdruckverfahren gemäß dem für die Kondensatorgegenelektrode(n) und ggf. zugeordneten Leiterbahnen gewünschten Layout eine zweite gleichartige Dielektrikumsschicht aufgebracht wird, welche zusätzlich eine Katalysator zur Aktivierung der Schicht für stromlose Metallisierung enthält, und daß anschließend diese zweite Dielektrikumsschicht aus einem stromlos arbeitenden Bad metallisiert wird, unter Bildung der Kondensatorgegenelektrode(n) und ggf. zugeordnet Leiterbahnen.

Die als Grundlage für diese stromlose Abscheidung der oberen oder Kondensatorgegenelektrode (und ggf. zugeordneten Leiterbahnen) dienende zweite Dielektrikumsschicht kann von gleicher oder ähnlicher Zusammensetzung wie die erste Dielektrikumsschicht sein, jedoch als Aktivierungskatalysator Pd bzw. eine reduzierbare Pd-Verbindung, beispielsweise $PdCl_2$ enthalten.

Die erste Dielektrikumsschicht wird vorzugsweise im wesentlichen ganzflächig, d. h. über den Kondensatorbereichen, den Leiterbahnen der ersten (unteren) Leiterebene und den Zwischenräumen aufgedruckt, wobei jedoch ggf. für die außerhalb der Kondensatorbereiche liegenden Bereiche eine Dielektrikumspaste niedriger Dielektrizitätskonstante, beispielsweise unter Verwendung von dielektrischen Füllstoffen aus der Gruppe $Al_2O_3$, MgO oder keramischen Substan-

zen niedriger Dielektrizitätskonstante, verwendet werden kann.

Ähnliches gilt für die Bedruckung mit der zweiten Dielektrikumsschicht.

Bei der Ausgestaltung der Erfindung als gedruckte Schaltung, welche eine Mehrzahl derartiger Kondensatoren und Leiterbahnen einschließlich der den Kondensatoren zugeordneten Anschluß- und Verbindungsleitungen umfaßt, kann gemäß einer bevorzugten Ausgestaltung der Erfindung vorgesehen sein, daß die gedruckte Schaltung jeweils in der gleichen Ebene wie die Kondensatorgrundelektroden und die Kondensatorgegenelektroden Leiterbahnen einschließlich den Kondensatorelektroden zugeordneter Anschluß- und Verbindungsleitungen aufweist, wobei die Herstellung der Kondensatoren und der Leiterbahnen in einem vollintegrierten, einheitlichen Verfahren erfolgen kann.

Die Erfindung eignet sich insbesondere zur Anwendung bei einer eine Mehrzahl derartiger Kondensatoren enthaltenden gedruckten Schaltung in Ausbildung als kapazitives Tastenaggregat für Eingabeinstrumente von Datenverarbeitungsanlagen, wobei die Kondensatoren in Matrixform angeordnet sind und die oberen oder Kondensatorgegenelektroden mit ihren in gleicher Ebene liegenden Anschlußleitungen nicht direkt verbunden sind, sondern an diese mittels tastenbetätigbarer Überbrückungskontakte wahlweise anschaltbar sind. Einzelheiten einer bevorzugten Ausführungsform dieser Art sind Gegenstand der Ansprüche 10 und 11. Die Erfindung ermöglicht so die einfache und billige Herstellung einer kapazitiven Eingabetastatur hoher Betriebszuverlässigkeit, da die den einzelnen Tasten zugeordneten Kapazitäten fest vorgegeben sind und durch Betätigung der jeweiligen Tasten ein- bzw. ausgeschaltet, nicht jedoch erst erzeugt bzw. in ihrem Betrag verändert werden.

Im folgenden werden Ausführungsbeispiele der Erfindung anhand der Zeichnung beschrieben. In dieser zeigen

Fig. 1 mit ihren Teilfiguren 1a bis 1f jeweils in schematisierter Querschnittsansicht eine insbesondere zur Ausbildung als kapazitives Tastenaggregat vorgesehene gedruckte Schaltung gemäß einer bevorzugten Ausführungsform der Erfindung, wobei die einzelnen Teilfiguren aufeinanderfolgende Verfahrensstadien veranschaulichen,

Fig. 2 ein Blockschaltbild eines Datenausgangs mit Dekodierschaltung unter Verwendung einer kapazitiven Eingabetastatur, zur Veranschaulichung einer typischen Anwendungsumgebung.

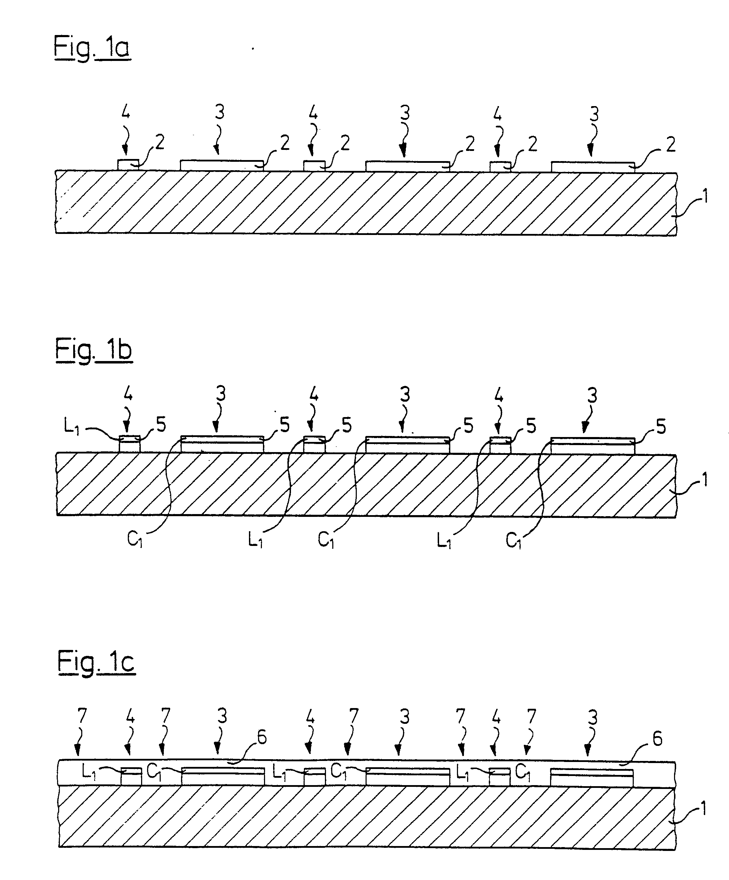

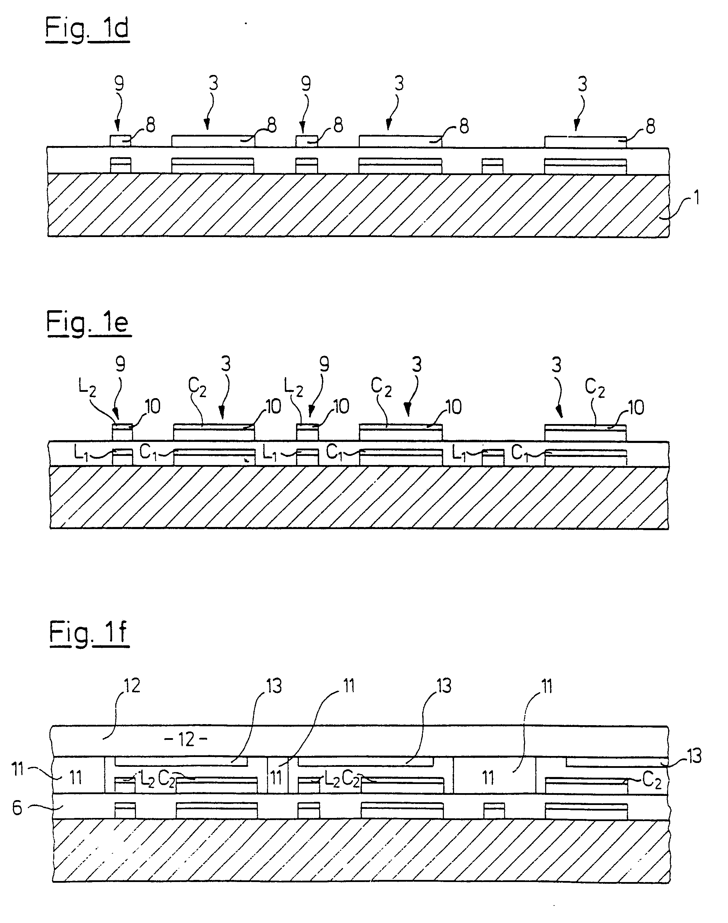

Im folgenden wird anhand von Fig. 1, deren Teilfiguren verschiedenen aufeinanderfolgenden Verfahrensstadien entsprechen, die Herstellung erfindungsgemäßer Dickschichtkondensatoren mit zugehörigen Leiterzügen in Druckschaltungstechnik erläutert, und zwar für den Beispielsfall einer Matrixanordnung von Kondensatoren für eine kapazitive Tastenanordnung, wie sie für Eingabevorrichtungen von Datenverarbeitungsanlagen Anwendung finden.

Zunächst werden auf einer Substrat- bzw. Trägerplatte 1, die beispielsweise aus einem Hartpapier oder aus einer Polyester- oder Polyimidfolie bestehen kann, die unteren Kondensatorelektroden bzw. -beläge sowie zugehörige Verbindungs- und Zuleitungen erzeugt. Im gezeigten Ausführungsbeispiel erfolgt dies in einem durch die Fig. 1a und 1b veranschaulichten zweistufigen Verfahren. In einem ersten Verfahrensschritt gemäß Fig. 1a wird die Träger- bzw. Substratplatte 1 im Siebdruckverfahren mit einer metallisierbaren Paste 2 gemäß einem für die Kondensatorbereiche 3 und die Leiterbahnenbereiche 4 gewünschten Lay-out bedruckt. In einem zweiten Verfahrensschritt gemäß Fig. 1b wird die metallisierbare Paste 2 sodann in einem stromlosen chemischen Bad metallisiert, wie bei 5 in Fig. 1b angedeutet. Diese beispielsweise aus Kupfer oder Nickel bestehenden, lötfähigen Metallisierungen bilden in den Kondensatorbereichen 3 die unteren Kondensatorelektroden bzw. -beläge C1, und in den Bereichen der Leiterbahnen 4 die eigentlichen Leiterpfade L1.

Eine alternative Möglichkeit der Herstellung der unteren Kondensatorelektroden in den Bereichen 3 und der Leiterbahnen in den Bereichen 4 wäre die Anwendung einer subtraktiven Technik, bei welcher aus einer ganzflächigen Metall-, beispielsweise Kupferkaschierung des Trägersubstrats durch selektives Ausätzen, beispielsweise unter Verwendung von im Lichtdruckverfahren im gewünschten Negativ-Lay-out hergestellten Photoresist-Ätzmasken, die Kondensatorelektroden C1 und die Leiterbahnen L1 erzeugt würden.

Als nächster bedeutsamer Schritt erfolgt nunmehr gemäß Fig. 1c die Erzeugung der Dielektrikumsschichten für die Kondensatoren. Im gezeigten Ausführungsbeispiel wird hierzu die gesamte Schaltung ganzflächig mit einer siebdruckfähigen Dielektrikumsmasse bedruckt. Nach dem Grundgedanken der Erfindung wird hierfür eine siebdruckfähige Masse verwendet, welche eine Dispersion von Dielektrikumspartikeln wie beispielsweise $ZnO$, $Al_2O_3$, $SrTiO_3$ oder $BaTiO_3$ in einem aushärtbaren Polymermaterial, wie beispielsweise Polyurethanharz oder anderen Harzen, wie beispielsweise Polyester, Epoxyharz, Melaminformaldehydharz enthält. Gemäß Fig. 1c werden sowohl die Kondensatorbereiche 3 als auch die Leiterbahnenbereiche 4 sowie auch die Zwischenräume zwischen diesen ganzflächig mit der Dielektrikumsmasse bedruckt. Alternativ können zunächst auch nur die Kondensatorbereiche 3 selektiv mit der Dielektrikumsmasse bedruckt werden, während die Leiterbahnenflächen und/ oder die Zwischenräume zur niveaumäßigen Egalisierung und funktionellen Isolierung mit anderen Pasten, vorzugsweise mit kleinerer Dielektrizitätskonstante bedruckt werden, um die Eigenkapazität der Leiterbahnen soweit als möglich zu verringern und einen möglichst großen Kapazitätssprung bei Ein- bzw. Ausschaltung der Kondensatoren als gewünschtes Schaltkriterium zu erhalten.

Die erfindungsgemäß als Dielektrikumsmaterial verwendete Dispersion auf einer Polymerharzbasis kann bei verhältnismäßig niedrigen Temperaturen im Bereich zwischen etwa 150 und etwa 230 °C ausgehärtet werden, was gegenüber den bekannten, mit Keramik- oder Glasfrittenpasten hergestellten Cermet-Kondensatoren, für welche Einbrenntemperaturen um 1 000 °C benötigt werden, einen wesentlichen Vorteil darstellt und insbesondere die Anwendung der erwähnten billigeren und weniger spröd-brüchigen Substratmaterialien ermöglicht.

Als nächstes folgt die Herstellung der zweiten oder oberen Kondensatorelektroden, vorteilhaft in Verbindung mit der Herstellung einer zweiten Leiterebene als Zuleitungen und Verbindungsleitungen für diese oberen Kondensatorbeläge. Im beschriebenen Ausführungsbeispiel erfolgt dies in zweistufigem Verfahren gemäß den Fig. 1d und 1e. Gemäß Fig. 1d wird vorbereitend zunächst eine zweite Dielektrikumsschicht 8 gemäß dem für die Kondensatorbereiche 3 und Leiterbahnbereiche 9 einer oberen, zweiten Leiterebene (welche im gezeigten Ausführungsbeispiel der Einfachheit halber in Überdeckung mit den Leiterbahnbereichen 4 der unteren Leiterebene angenommen sind) erforderlichen Lay-out auf die zuvor aufgebrachte Dielektrikumsbedruckung 6 (Fig. 1c) im Siebdruck aufgedruckt. Die Dielektrikumsschicht 8 kann von gleicher oder ähnlicher Zusammensetzung wie die Dielektrikumsschicht 6 sein, mit dem Unterschied jedoch, daß sie einen Aktivator auf Palladiumbasis enthält, wodurch diese zweite Dielektrikumsschicht 8 stromlos metallisierbar wird. Als Metallisierungsaktivator bzw. -katalysator kann vorzugsweise elementares Palladium, beispielsweise in einem Gehalt von 0,1 % in der Dielektrikumsmasse 8 enthalten sein, oder aber auch eine Palladium-Verbindung, wie beispielsweise $PdCl_2$ ; bei Verwendung einer derartigen Pd-Verbindung müßte jedoch nach dem Einbrennen der Schicht die Verbindung in geeigneter Weise, beispielsweise durch Behandlung in einem chemischen Bad, in elementares Pd übergeführt werden, um die gewünschte Aktivierung der zweiten Dielektrikumsschicht 8 für die nachfolgende stromlose Metallisierung zu gewährleisten.

Nach Aushärtung der zweiten, den erwähnten Aktivator enthaltenden Dielektrikumsschicht 8, die wiederum bei relativ niedrigen Temperaturen in der Größenordnung zwischen ca. 150 und ca. 230 °C erfolgen kann, kann nunmehr in einem folgenden Verfahrensschritt gemäß Fig. 1e diese zweite Dielektrikumsschicht 8 ohne weitere Vorbehandlung (bei anfänglicher Einlagerung von elementarem Pd als Aktivierungskatalysator) bzw. nach der erwähnten chemischen Reduktions-Vorbehandlung (bei anfänglicher Verwendung einer Palladium-Verbindung als Aktivierungskomponente) in einem stromlos arbeitenden Metallisierungsbad metallisiert werden, wie bei 10 in Fig. 1e angedeutet. Hierdurch werden in den Kondensatorbereichen 3 die zweiten oder oberen Kondensatorelektroden bzw. -beläge C2 und in den Leiterbahnbereichen 9 die Leiterbahnen L2 der oberen oder zweiten Leiterebene gebildet.

Ähnlich wie bei der Herstellung der unteren Kondensatorelektroden C1 und der Leiterbahnen L1 der unteren Leiterebene gemäß den Fig. 1a und 1b könnte auch bei der Herstellung der oberen Elektroden C2 und oberen Leiterbahnen L2 die Bedruckung in Fig. 1a in den Kondensatorbereichen 3 einerseits und in den Leiterbahnbereichen 9 andererseits mit (für stromlose Metallisierung aktivierten) Dielektrikumsmassen unterschiedlicher Dielektrizitätkonstante erfolgen. Gemäß einer weiteren Alternative könnte schließlich auch die Herstellung der Kondensatorelektroden C2 und oberen Leiterbahnen L2 statt wie in zweistufigem Verfahren gemäß den Fig. 1d und 1e für die bevorzugte stromlose Metallisierung auch einstufig durch Bedrucken mit einer elektrisch leitenden Siebdruckpaste, beispielsweise Silber- oder Nickelpaste erfolgen. Hierbei ergäben sich jedoch wiederum die o. e. Probleme einer eventuellen Silberwanderung und der Nachteil, daß die so hergestellten Metallschichten nicht ohne weiteres lötbar wären.

Mit dem gemäß Fig. 1e erreichten Stand ist die Herstellung der Dickschichtkondensatoren und der zugehörigen Anschluß- und Verbindungsleitungen an sich abgeschlossen. Die freien Zwischenräume zwischen den Kondensatorflächen C2 und den Leiterbahnen L2 könnten beispielsweise mit der gleichen oder einer ähnlichen Siebdruckpaste gleicher oder unterschiedlicher (kleinerer) Dielektrikumskonstante bedruckt werden, wodurch eine praktisch ebene Oberfläche erhalten würde, da die Schichtdicke der Metallisierungen 10 in der Größenordnung unter 10 μm liegt. Als äußere Schutz- und Passivierungsschicht könnte ganzflächig (unter Aussparung der Anschlußpunkte) ein Isolierlack aufgebracht werden.

Die bei der bevorzugt angewandten stromlosen Metallisierung zur Herstellung der Kondensatorelektroden und/oder der Leiterbahnen erhaltenen Metallschichten sind voll lötbar und können unmittelbar mit Chipbauteilen verbunden werden. Die durch stromlose Metallisierung erhaltenen Metallschichten besitzen auch den Vorteil einer besonders guten Haftung durch den herstellungsmäßig bedingten direkten innigen Kontakt mit den sie tragenden Dielektrikumsschichten.

Im vorliegenden Ausführungsbeispiel soll noch anhand von Fig. 1f die spezielle Anwendung und Ausbildung erfindungsgemäßer Dickschichtkondensatoren als kapazitive Tastatur für Eingabeinstrumente von Datenverarbeitungsanlagen beschrieben werden, was ein bevorzugtes Anwendungsgebiet der erfindungsgemäßen in Druckschaltungstechnik hergestellten Kondensatorschaltungen bildet. Für diesen Anwendungszweck ist eine größere Anzahl von Kondensatorbereichen 3 vorgesehen, welche in Matrixform gemäß einem für Eingabetastaturen üblichen Tastenfeld angeordnet sind. Für diese besondere Anwendung unterbleibt eine Auffüllung der Zwischenräume zwischen den Kondensatorbelägen C2 und den Leiterbahnen L2 der oberen Ebene, und die jeweiligen Anschlußzuleitungen L2 zu den Kondensatorelektroden C2 werden mit diesen nicht direkt verbunden. Vielmehr ist eine wahlweise Ein- bzw. Ausschaltung der einzelnen Kondensatoren durch Überbrückungskontakte, welche durch äußere Tastenbetätigung betätigbar sind, vorgesehen. Gemäß Fig. 1f werden auf die untere, erste Dielektrikumsschicht 6 an geeigneten Stellen in Zwischenräumen zwischen den Kondensatorbereichen 3 und den Leiterbahnen L2 der oberen Leiterebene (jedoch nicht zwischen einem jeweiligen Kondensatorbelag C2 und seiner zugehörigen Anschlußleitung L2) Abstandsorgane 11 eingebracht. Vorzugsweise kann es sich hierbei um eine einstückige Abstandsfolie 11 mit entsprechenden Ausschnitten in den Bereichen der zu kontaktierenden Kondensatoren C2 und Anschlußleitungen L2 handeln. Die Abstandsfolie 11 kann beispielsweise eine Polyäthylen- oder Polyester-Folie sein. Über diese Abstandsfolie 11 und durch diese abgestützt wird sodann eine die gesamte Matrixanordnung überdeckende Außenfolie 12 aufgelegt, welche an ihrer Unterseite in den den Ausnehmungen der Abstandsfolie 11 entsprechenden Bereichen den jeweiligen Kondensatorelektroden C2 und Anschlußleitungen L2 zugeordnete metallische Überbrückungskontakte 13, beispielsweise aus Nickel, Silber und vorzugsweise aus Gold aufgedruckt aufweist. Die Kontaktfolie 12 kann ebenfalls aus Polyäthylen oder Polyester bestehen, für besonders hochtemperaturbelastete Anwendungszwecke auch aus Polyimid. Die Höhe (Schichtstärke) der Abstandsfolie 11 ist so bemessen, daß die Überbrückungskontakte 13 im normalen Ruhezustand von den Kondensatorelektroden C2 und den zugehörigen Anschlußleitungen L2 abgehoben sind. Durch Niederdrücken der Folie 12 in den den jeweiligen Überbrückungskontakten 13 entsprechenden Bereichen wird der betreffende zugeordnete Kondensator C2, C1 in die Schaltung eingeschaltet bzw. durch Loslassen des Tastenbereichs wieder ausgeschaltet. Diese Ausbildung kapazitiver Tastenfelder hat den Vorteil, daß die den einzelnen Tasten zugeordneten Kapazitäten fest vorgegeben sind und durch Betätigung der jeweiligen Tasten nur eingeschaltet, aber nicht erzeugt werden. Auf diese Weise können die Kapazitätstoleranzen gering gehalten werden, da die einzelnen, in der beschriebenen Weise ausgebildeten und in Druckschaltungstechnik ausgeführten Kondensatoren mit relativ hoher Genauigkeit herstellbar sind und als Schaltkriterium die volle Zu- bzw. volle Abschaltung der einzelnen Kondensatoren dient. Hierdurch wird ein großer Kapazitätssprung bei Einschalten eines Kondensators durch Betätigung der Kontakttaste als Schaltkriterium erreicht, insbesondere bei der o. e. bevorzugten Ausführung der außerhalb der Kondensatorbereiche liegenden Bereiche mit Dielektrikumspasten niedrigerer Dielektrizitätskonstante.

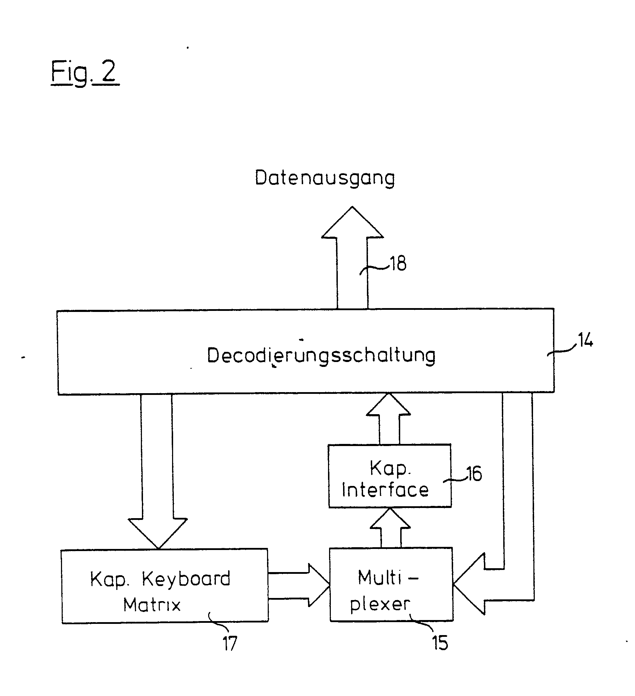

Fig. 2 veranschaulicht eine typische Anwendungsumgebung einer derartigen kapazitiven Eingabetastatur, in Gestalt eines Blockschaltbilds eines Datenausgangs mit Dekodierschaltung. Mit 14 ist die eigentliche Dekodierschaltung bezeichnet, 15 ist eine Multiplexer-Schaltung, die über eine kapazitive Interface-Vorrichtung 16 mit der Dekodierschaltung verbunden ist. Mit 17 ist eine kapazitive Tastaturmatrix angedeutet, welche entsprechend der vorstehend beschriebenen Ausführungsform der Erfindung ausgebildet sein kann. Bei 18 ist der Datenausgang angedeutet der Daten- und Wirkungsfluß zwischen den verschiedenen Teilen der Gesamtanordnung ist durch die Pfeile angedeutet.

Die Erfindung wurde vorstehend anhand bevorzugter Ausführungsbeispiele erläutert, die selbstverständlich in mannigfacher Weise abgewandelt werden können, ohne daß hierdurch der Rahmen der Erfindung verlassen wird. Wesentlich für den Grundgedanken der Erfindung ist die Herstellung der Kondensatoren in der Technologie gedruckter Schaltungen angepaßter Dickschichttechnik unter Verwendung einer Siebbruckfähigen Dielektrikumsmasse auf einer bei relativ niedrigen Temperaturen aushärtbaren Polymerharzbasis, vorzugsweise in Verbindung mit der Herstellung der Kondensatorelektroden und/oder der Leiterbahnen durch stromlose Metallisierung unter Verwendung von hierfür aktivierten Dielektrikumsschichten.

## Patentansprüche

1. Dickschicht-Kondensator für ein in Druckschaltungstechnik hergestelltes kapazitives Tastenaggregat für Eingabeinstrumente von Datenverarbeitungsanlagen, mit einer auf einer Substrat- oder Trägerplatte vorgesehenen Grundelektrode, einem auf diese siebgedruckten, polymeren Dickschicht-Dielektrikum und einer über diesem in Ausrichtung mit der Grundelektrode vorgesehenen Gegenelektrode, dadurch gekennzeichnet, daß die Kondensatorgrundelektrode (C1) und gegebenenfalls zugeordneten Leitungsanschlüsse auf aktivierten Siebdruckschichten (2) stromlos abgeschiedene Metallisierungen oder subtraktiv aus kaschiertem Substratmaterial erzeugte Metallflächen (5) sind, daß das Dielektrikum (6) aus einer im Siebdruck aufgebrachten ausgehärteten Dispersion dielektrischer Füllstoffe in einem Polymermaterial mit relativ niedriger Aushärtetemperatur im Bereich von 150° bis 230 °C besteht, und daß die Gegenelektrode (C2, Figur 1e) und ggf. zugeordneten Leitungsanschlüsse stromlos abgeschiedene Metallisierungen (10) auf einer zweiten, für stromlose Metallisierung aktivierten, katalysatorgefüllten Dielektrikumsschicht (8) sind, die über dem ersten Dickschicht-Dielektrikum (6) angeordnet ist.

2. Kondensator nach Anspruch 1, dadurch gekennzeichnet, daß das Dickschicht-Dielektrikum als Polymermaterial ein oder mehrere Polymerharz(e) aus der Gruppe Polyurethan-, Polyester-, Epoxy-, Melaminformaldehydharz enthält.

3. Kondensator nach Anspruch 1 oder 2, dadurch gekennzeichnet, daß die stromlos metallisierbare Siebdruck- bzw. Dielektrikumsschicht (8) als Aktivierungskatalysator Palladium oder eine Pd-Verbindung enthält.

4. Kondensator nach einem oder mehreren der vorhergehenden Ansprüche, dadurch gekennzeichnet, daß die Substrat- bzw. Trägerplatte (1) aus Hartpapier, glasfaserverstärktem Kunststoffmaterial, Ryton, Polyester- oder Polyimid-Folien oder Duroplast-Material besteht.

5. Gedruckte Schaltung mit einem oder mehreren Kondensator(en) nach einem oder mehreren der vorhergehenden Ansprüche und Anschluß- bzw. Verbindungsleitungen für den bzw. die Kondensator(en), dadurch gekennzeichnet, daß die außerhalb der Kondensatorbereiche (3) liegenden Bereiche (4, 7) aus einem Material niedrigerer Dielektrizitätskonstante als das Dickschicht-Dielektrikum der Kondensatoren besteht.

6. Gedruckte Schaltung nach Anspruch 5, dadurch gekennzeichnet, daß die außerhalb der Kondensatoren liegenden Bereiche aus einer siebdruckfähigen Dispersion von Füllstoffen niedriger Dielektrizitätskonstante in einem organischen Lack oder Harz bestehen.

7. Gedruckte Schaltung nach einem der Ansprüche 5 oder 6, dadurch gekennzeichnet, daß sie jeweils in der gleichen Ebene wie die Kondensatorgrundelektroden (C1) und die Kondensatorgegenelektroden (C2) Leiterbahnen (L1, L2) einschließlich den Kondensatorelektroden zugeordneter Anschluß- und Verbindungsleitungen aufweist.

8. Gedruckte Schaltung nach einem oder mehreren der vorhergehenden Ansprüche, dadurch gekennzeichnet, daß die Substrat- bzw. Trägerplatte (1) aus Hartpapier, glasfaserverstärktem Kunststoffmaterial, Ryton, Polyester- oder Polimid-Folien oder Duroplast-Material besteht.

9. Gedruckte Schaltung nach einem oder mehreren der vorhergehenden Ansprüche mit mehreren Kondensatoren, in Ausbildung als kapazitives Tastenaggregat für Eingabeinstrumente von Datenverarbeitungsanlagen, dadurch gekennzeichnet, daß die Kondensatoren (C1,2) in Matrixform angeordnet sind und daß die oberen oder Kondensatorgegenelektroden (C2) mit ihren in gleicher Ebene liegenden Anschlußleitungen (L2) nicht direkt verbunden sind, sondern an diese mittels tastenbetätigbarer Überbrückungskontakte (13) wahlweise anschaltbar sind (Fig. 1f).

10. Gedruckte Schaltung nach Anspruch 9, dadurch gekennzeichnet, daß in den Zwischenräumen der Kondensatormatrixanordnung Abstandsmittel (11, Fig. 1f) vorgesehen sind, welche sich über die Ebene der oberen oder Kondensatorgegenelektroden (2) und der zugeordneten Leiterbahnen (L2) erheben, und daß auf diesen Abstandsmitteln (11) eine Halterungsvorrichtung (12) für die mit den oberen oder Kondensatorgegenelektroden (C2) und den zugeordneten Anschlußleitungen (L2) zusammenwirkenden beweglichen Überbrückungskontakte (13) angeordnet ist.

11. Gedruckte Schaltung nach Anspruch 10, dadurch gekennzeichnet, daß als Abstandsmittel eine einstückige Folie (11) mit den Kondensatoren (C2) und ihren zugeordneten Anschlußleitungen (L2) entsprechenden Ausnehmungen vorgesehen ist, und daß die Halterung für die Überbrückungskontakte aus einer über die Abstandsfolie (11) aufgelegten biegsamen Folie (12) besteht, welche an ihrer Unterseite in den Ausnehmungen der Abstandsfolie (11) und in Zuordnung zu den oberen oder Kondensatorgegenelektroden (C2) und den zugeordneten Leiterbahnen (L2) aufgedruckte Metallisierungen (13) als Überbrückungskontakte aufweist.

12. Verfahren zur Herstellung eines für ein in Druckschaltungstechnik hergestelltes, kapazitives Tastenaggregat geeigneten Dickschicht-Kondensators in Druckschaltungstechnik bzw. einer einen oder mehrere solcher Dickschichtkondensator(en) mit zugeordneten Leiterbahnen enthaltenden gedruckten Schaltung nach einem oder mehreren der vorhergehenden Ansprüche, bei welchem auf einer Substrat- bzw. Trägerplatte die jeweilige untere oder Kondensatorgrundelektrode des bzw. der Kondensatoren erzeugt, sodann auf der bzw. den Kondensatorgrundelektrode(n) im Siebdruckverfahren ein Dickschicht-Dielektrikum aufgebracht und nach Aushärtung des Dielektrikums die Kondensatorgegenelektrode(n) in Ausrichtung mit der bzw. den Kondensatorgrundelektrode(n) aufgebracht wird, und das Dielektrikum eine siebdruckfähige Dispersion dielektrischer Füllstoffe in einem bei relativ niedrigen Temperaturen aushärtbaren Polymermaterial ist, dadurch gekennzeichnet, daß zur Erzeugung der oberen oder Kondensatorgegenelektrode(n) (C2) und ggf. zugeordneter Leiterbahnen (L2) auf die erste Dielektrikumsschicht (6) nach deren Aushärtung im Siebdruckverfahren gemäß dem für den Kondensatorgegenelektrode(n) (C2) und ggf. zugeordneten Leiterbahnen (12) gewünschten Lay-out eine zweite gleichartige Dielektrikumsschicht (8) aufgebracht wird, welche zusätzlich einen Katalysator zur Aktivierung der Schicht für stromlose Metallisierung enthält, und daß anschließend diese zweite Dielektrikumsschicht (8) aus einem stromlos arbeitenden Bad metallisiert wird (10, Fig. 1e), unter Bildung der Kondensatorgegenelektrode(n) (C2) und ggf. zugeordneter Leiterbahnen (L2).

13. Verfahren nach Anspruch 12, dadurch gekennzeichnet, daß die siebdruckfähige Dispersion zur Erzeugung des Dickschicht-Dielektrikums (6) als Polymermaterial ein oder mehrere Polymerharz(e) aus der Gruppe Polyurethan-, Polyester-, Epoxy-, Melaminformaldehydharz enthält.

14. Verfahren nach Anspruch 12 oder 13, dadurch gekennzeichnet, daß zur Erzeugung der unteren oder Kondensatorgrundelektrode(n) (C1) sowie ggf. zugeordneter Leiterbahnen (L1) auf die Substrat- bzw. Trägerplatte (1) eine für stromlose Metallisierung aktivierte Siebdruckpaste im Siebdruckverfahren nach dem für die Kondensatoren und Leiterbahnen gewünschten Lay-out aufgedruckt wird und nach Aushärtung im stromlos chemischen Bad metallisiert wird (5), unter Erzeugung der Kondensatorgrundelektrode(n) (C1) sowie ggf. der Leiterbahnen (L1) (Fig. 1a und 1b).

15. Verfahren nach Anspruch 12 oder 13, dadurch gekennzeichnet, daß die untere(n) oder Kondensatorgrundelektrode(n) (C1) sowie ggf. zugeordnete Leiterbahnen (L1) in subtraktivem Verfahren durch selektive Ätzung einer Metallkaschierung der Substrat- bzw. Trägerplatte erzeugt werden.

16. Verfahren nach einem oder mehreren der Ansprüche 12 bis 15, dadurch gekennzeichnet, daß die Aushärtung der Dielektrikumsschicht bzw. -schichten (6, Fig. 1c ; 8, Fig. 1d) bei Temperaturen im Bereich von 150 °C bis 230 °C erfolgt.

17. Verfahren zur Herstellung einer Dickschicht-Kondensatoren für ein kapazitives Tastenaggregat und zugehörige Leitungsverbindungen enthaltenden gedruckten Schaltung, gekennzeichnet durch die folgenden Verfahrensschritte:

a) Auf eine Substrat- bzw. Trägerplatte (1) wird eine stromlos metallisierbare Siebdruckpaste (2) im Siebdruckverfahren in dem für die Kondensatorbereiche (3, Figur 1a) und zugehörige Leiterbahnbereiche (4) einer unteren Leiterbahnebene gewünschten Lay-out aufgedruckt (Figur 1a) ;

b) nach Aushärtung wird die aufgedruckte Siebdruckpaste (2) im stromlos arbeitenden chemischen Bad metallisiert, unter Bildung der unteren oder Kondensatorgrundelektroden (C1) und der zugeordneten Leiterbahnen (L1) einer unteren Leiterbahnebene (Figur 1b) ;

c) als nächstes wird die Schaltungsplatte mit einer bei Temperaturen zwischen 150° und 230 °C aushärtbaren Dielektrikumsschicht (6) bedruckt, welche eine Dispersion dielektrischer Füllstoffe in einem Polymerharzmaterial enthält (Figur 1c), wobei in den außerhalb der Kondensatorbereiche (3) liegenden Bereiche (4, 7) eine Dielektrikumsschicht niedrigerer Dielektrizitätskonstante verwendet werden kann (Figur 1c) ;

d) die Dielektrikumsschicht (6) wird bei Temperaturen im Bereich zwischen 150 °C bis 230 °C ausgehärtet ;

e) auf die erste Dielektrikumsschicht (6) wird in den Kondensatorbereichen (3, Figur 1d) und ggf. in den für Leiterbahnen einer zweiten Leiterebene vorgesehenen Bereichen (9) eine zweite Dielektrikumsschicht (8) im Siebdruckverfahren in dem gewünschten Lay-out aufgedruckt, welche einen Katalysatorbestandteil zur Aktivierung der Schicht für stromlose Metallisierung enthält (Figur 1d), wobei wiederum in den außerhalb der Kondensatorbereiche (3) gelegenen Bereichen eine Dielektrikumsschicht niedrigerer Dielektrizitätskonstante und ohne den Katalysatorbestandteil verwendet werden kann ;

f) die zweite Dielektrikumsschicht (8) wird bei Temperaturen im Bereich zwischen 150 °C und 230 °C, ausgehärtet ;

g) die zweite Dielektrikumsschicht (8) wird im stromlos arbeitenden chemischen Bad metallisiert (10, Figur 1e), unter Erzeugung der oberen oder Kondensatorgegenelektroden (C2) und der zugehörigen Leiterbahnen (L2) einer zweiten Leiterebene (Figur 1e).

18. Verfahren nach Anspruch 17, dadurch gekennzeichnet, daß die Dielektrikumsschichten (6, 8, Fig. 1c, 1d) in den Kondensatorbereichen (3) einen oder mehrere dielektrische Füllstoffe aus der Gruppe ZnO, $Al_2O_3$, $SrTiO_3$, BaTiO oder Keramiksubstanzen hoher Dielektrizitätskonstante enthalten.

19. Verfahren nach Anspruch 17 oder 18, dadurch gekennzeichnet, daß die Dielektrikumsschichten (6, 8) in den außerhalb der Kondensatorbereiche (3) liegenden Bereichen einen oder mehrere dielektrische Füllstoffe aus der Gruppe $Al_2O_3$, MgO oder keramische Substanzen niedriger Dielektrizitätskonstante enthalten.

20. Verfahren nach einem oder mehreren der Ansprüche 17 bis 19, dadurch gekennzeichnet, daß die Dielektrikumsschichten (6, 8) die dielektrischen Füllstoffe in einem Polymerharz aus der Gruppe Polyurethan-, Polyester-, Epoxy-, Melaminformaldehydharz dispergiert enthalten.

21. Verfahren nach einem oder mehreren der Ansprüche 17 bis 20, dadurch gekennzeichnet, daß die zweite, für stromlose Metallisierung aktivierte Dielektrikumsschicht (8) als Aktivierungskatalysator Pd oder eine reduzierbare Pd-Verbindung enthält.

## Claims

1. Thick-film capacitor for a capacitive key unit, which is produced by the printed circuit technique, for input instruments of data processing equipment, having a base electrode, which is provided on a substrate plate or carrier plate, a polymer thick-film dielectric, which is screen-printed on the latter, and a counter-electrode provided above the latter in alignment with the base electrode, characterised in that the capacitor base electrode (C1) and, if applicable, associated line terminals on activated screen-printed layers (2) are metallizations deposited without current or metal surfaces (5) produced substractively from coated substrate material, in that the dielectric (6) consists of a hardened dispersion, which is applied by the screen-printing process, of dielectric filling materials in a polymer material with comparatively low hardening temperature in the range of 150 °C to 230 °C and in that the counter-electrode (C2, Figure 1e), and, if applicable, associated line terminals are metallizations (10), which are deposited without current, on a second dielectric layer (8), which is activated for currentless metallization, is filled with a catalyst and is arranged above the first thick-film dielectric (6).

2. Capacitor according to claim 1, characterised in that the thick-film dielectric contains as a polymer material one or several polymer resin(s) from the group polyurethane resin, polyester resin, epoxy resin, melamine formaldehyde resin.

3. Capacitor according to claim 1 or 2, characterised in that the screen-printed or dielectric layer (8), which can be metallized without current, contains palladium or a Pd compound as an activating catalyst.

4. Capacitor according to one or several of the preceding claims, characterised in that the substrate plate or carrier plate (1) consists of hard paper, glass fibre-reinforced plastics material, ryton, polyester- or polyimide-foils or duroplastic material.

5. Printed circuit having one or several capacitor(s) according to one or several of the preceding claims and terminal or connection lines for the capacitor or capacitors, characterised in that the areas (4, 7) lying outside the capacitor areas (3) consists (sic) of a material with a lower dielectric constant than the thick-film dielectric of the capacitors.

6. Printed circuit according to claim 5, characterised in that the areas lying outside the capacitors consist of a screen-printable dispersion of filling materials with a low dielectric constant in an organic lacquer or resin.

7. Printed circuit according to one of the claims 5 or 6, characterised in that it has, in each case, in the same plane as the capacitor base electrodes (C1) and the capacitor counter-electrodes (C2) printed conductors (L1, L2), including terminal and connection lines associated with the capacitor electrodes.

8. Printed circuit according to one or several of the preceding claims, characterised in that the substrate plate or carrier plate (1) consists of hard paper, glass fibre-reinforced plastics material, ryton, polyester- or polyimide-foils or duroplastic material.

9. Printed circuit according to one or several of the preceding claims having several capacitors, in development as a capacitive key unit for input instruments of data processing equipment, characterised in that the capacitors (C1, 2) are arranged in matrix form and in that the upper or capacitor counter-electrodes (C2) are not directly linked with their terminal lines (L2) lying in the same plane, but can be connected selectively to these by means of key-operated bridging contacts (13) (Figure 1f).

10. Printed circuit according to claim 9, characterised in that provided in the interspaces of the capacitor matrix arrangement there are spacing means (11, Figure 1f) which rise above the plane of the upper or capacitor counter-electrodes (2) and the associated printed conductors (L2) and in that arranged on these spacing means (11) there is a holding support arrangement (12) for the movable bridging contacts (13) which cooperate with the upper or capacitor counter-electrodes (C2) and the associated terminal lines (L2).

11. Printed circuit according to claim 10, characterised in that a one-piece foil (11) with the capacitors (C2) and recesses corresponding to their associated terminal lines (L2) is provided as a spacing means and in that the holding support for the bridging contacts consists of a flexible foil (12) which is laid over the spacing foil (11) and which has on its lower side in the recesses of the spacing foil (11) and in coordination with the upper or capacitor counter-electrodes (C2) and the associated printed conductors (L2) metallizations (13) printed thereon as bridging contacts.

12. Method for producing by the printed circuit technique a thick-film capacitor, which is suitable for a capacitive key unit produced by the printed circuit technique, or for producing a printed circuit containing one or several such thick-film capacitor(s) with associated printed conductors according to one or several of the preceding claims, by which method the respective lower or capacitor base electrode of the capacitor or capacitors is produced on a substrate plate or carrier plate, subsequently a thick-film dielectric is applied to the capacitor base electrode or electrodes by the screen-printing process and after hardening of the dielectric the capacitor counter-electrode or -electrodes is applied in alignment with the capacitor base electrode or electrodes and the dielectric is a screen-printable dispersion of dielectric filling materials in a polymer material which can be hardened at comparatively low temperatures, characterised in that in order to produce the upper or capacitor counter-electrode(s) (C2) and, if applicable, associated printed conductors (L2) there is applied to the first dielectric layer (6) after the latter has hardened by the screen-printing process according to the desired layout for the capacitor counter-electrode(s) (C2) and, if applicable, associated printed conductors (12) (SIC), a second similar dielectric layer (8) which contains, in addition, a catalyst for activation of the layer for currentless metallization and in that subsequently this second dielectric layer (8) is metallized out of a bath operating without current (10, Fig. 1e), with formation of the capacitor counter-electrode(s) (C2) and, if applicable, associated printed conductors (L2).

13. Method according to claim 12, characterised in that the screen-printable dispersion for producing the thick-film dielectric (6) contains as a polymer material one or several polymer resin(s) from the group polyurethane resin, polyester resin, epoxy resin, melamine formaldehyde resin.

14. Method according to claim 12 or 13, characterized in that for the purpose of producing the lower or capacitor base electrode(s) (C1) and also, if applicable, associated printed conductors (L1) a screen print paste, activated for currentless metallization, is printed onto the substrate plate or carrier plate (1) by the screen-printing process according to the desired layout for the capacitors and printed conductors and after hardening is metallized (5) in a bath, which is chemical without current, with production of the capacitor base electrode(s) (C1) and also, if applicable, the printed conductors (L1) (Fig. 1a and 1b).

15. Method according to claim 12 or 13, characterised in that the lower or capacitor base electrode(s) (C1) and also, if applicable, associated printed conductors (L1) are produced in the subtractive process through selective etching of a metal cladding of the substrate plate or carrier plate.

16. Method according to one or several of the claims 12 to 15, characterised in that the hardening of the dielectric layer or layers (6, Fig. 1c ; 8, Fig. 1d) takes place at temperatures in the range of 150 °C to 230 °C.

17. Method for the production of a printed circuit containing thick-film capacitors for a capacitive key unit and pertinent line connections, characterised by the following method steps :

a) a screen print paste (2), which can be metallized without current, is printed onto a substrate plate or carrier plate (1) by the screen-printing process in the desired layout for the capacitor areas (3, Figure 1a) and pertinent printed conductor areas (4) of a lower printed conductor plane (Figure 1a) ;

b) after hardening the printed screen print paste (2) is metallized in a chemical bath which operates without current, with formation of the lower or capacitor base electrodes (C1) and the associated printed conductors (L1) of a lower printed conductor plane (Figure 1b) ;

c) the printed card is next printed with a dielectric layer (6) which can harden at temperatures between 150° and 230 °C and which contains a dispersion of dielectric filling materials in a polymer resin material (Figure 1c), in which case a dielectric layer with a lower dielectric constant can be used in the areas (4, 7) lying outside the capacitor areas (3) (Figure 1c) ;

d) the dielectric layer (6) is hardened at temperatures in the range between 150 °C and 230 °C ;

e) a second dielectric layer (8) is printed onto the first dielectric layer (6) in the capacitor areas (3, Figure 1d) and, if applicable, in the areas (9) provided for printed conductors of a second conductor plane by the screen-printing process in the desired layout, which dielectric layer (8) contains a catalyst constituent for activating the layer for currentless metallization (Figure 1d), in which case again in the areas lying outside the capacitor areas (3) a dielectric layer with a lower dielectric constant and without the catalyst constituent can be used ;

f) the second dielectric layer (8) is hardened at temperatures in the range between 150 °C and 230 °C ;

g) the second dielectric layer (8) is metallized in a chemical bath operating without current (10, Figure 1e), with production of the upper or capacitor counter-electrodes (C2) and the pertinent printed conductors (L2) of a second conductor plane (Figure 1e).

18. Method according to claim 17, characterised in that the dielectric layers (6, 8, Fig. 1c, 1d) in the capacitor areas (3) contain one or several dielectric filling materials from the group ZnO, $Al_2O_3$, $SrTiO_3$, BaTiO or ceramic substances with a high dielectric constant.

19. Method according to claim 17 or 18, characterised in that the dielectric layers (6, 8) in the areas lying outside the capacitor areas (3) contain one or several dielectric filling materials from the group $Al_2O_3$, MgO or ceramic substances with a low dielectric constant.

20. Method according to one or several of the claims 17 to 19, characterised in that the dielectric layers (6, 8) contain the dielectric filling materials in a polymer resin from the group polyurethane resin, polyester resin, epoxy resin, melamine formaldehyde resin in a dispersed manner.

21. Method according to one or several of the claims 17 to 20, characterised in that the second dielectric layer (8), which is activated for currentless metallization, contains as an activating catalyst Pd or a reducible Pd compound.

**Revendications**

1. Condensateur à couche épaisse pour un bloc capacitif à touches fabriqué par la technique des circuits imprimés, pour des instruments d'entrée d'installations de traitement de l'information, comportant une électrode de masse prévue sur une plaquette de substrat ou plaquette support, un diélectrique à couche épaisse polymère imprimé par sérigraphie ainsi qu'une contre-électrode prévue sur ce diélectrique dans l'alignement de l'électrode de masse, caractérisé en ce que l'électrode de masse (C1) du condensateur et éventuellement les raccordements de conducteurs correspondants sont des couches déposées par métallisation sans passage de courant sur des couches (2) rapportées par sérigraphie et activées ou bien des surfaces métalliques (5) produites par élimination à partir d'un matériau substrat rapporté par doublage ; en ce que le diélectrique (6) est constitué d'une dispersion, rapportée par sérigraphie et durcie, de matières diélectriques de charge dans un matériau polymère présentant une température de durcissement relativement basse sur la plage de 150 à 230 °C, et en ce que la contre-électrode (C2, figure 1e) et éventuellement les raccordements de conducteurs correspondants sont des couches (10) déposées par métallisation, sans passage de courant, sur une seconde couche diélectrique (8), contenant une charge de catalyseur, activée pour permettre une métallisation sans passage de courant et disposée au-dessus du premier diélectrique (6) à couche épaisse.

2. Condensateur selon la revendication 1, caractérisé en ce que le diélectrique à couche épaisse contient comme matériau polymère une ou plusieurs résines polymères du groupe résine de polyuréthanne, résine de polyester, résine époxyde, résine de mélamine formaldéhyde.

3. Condensateur selon la revendication 1 ou 2, caractérisé en ce que la couche (8) obtenue par sérigraphie ou couche diélectrique, métallisable sans passage de courant, contient comme catalyseur d'activation du palladium ou un composé du Pd.

4. Condensateur selon une ou plusieurs des revendications précédentes, caractérisé, en ce que la plaquette substrat ou plaquette support (1) est constituée de papier stratifié, de matériau plastique armé de fibres de verre, de « ryton », de feuilles de polyester ou de polyimide ou de matériau thermodurcissable.

5. Circuit imprimé comportant un ou plusieurs condensateurs selon une ou plusieurs des revendications précédentes et des conducteurs de raccordement et de liaison pour le ou les condensateurs, caractérisé en ce que les zones (4, 7) situées à l'extérieur des zones (3) formant condensateurs, sont constituées d'un matériau de constante diélectrique plus faible formant le diélectrique à couche épaisse des condensateurs.

6. Circuit imprimé selon la revendication 5, caractérisé en ce que les zones situées à l'extérieur des condensateurs sont constituées d'une dispersion, pouvant être rapportée par sérigraphie, de matières de charge de constante diélectrique plus faible dans un vernis ou laque organique ou dans une résine.

7. Circuit imprimé selon l'une des revendications 5 ou 6, caractérisé en ce qu'il présente respectivement dans le même plan que les électrodes de masse (C1) des condensateurs et que les contre-électrodes de condensateurs (C2) les rubans conducteurs (L1, L2) y compris les conducteurs de raccordement et de liaison correspondant aux électrodes des condensateurs.

8. Circuit imprimé selon une ou plusieurs des revendications précédentes, caractérisé, en ce que la plaquette substrat ou plaquette support (1) est constituée de papier stratifié, de matériau plastique armé de fibres de verre, de « ryton », de feuilles de polyester ou de polyimide ou de matériau thermodurcissable.

9. Circuit imprimé selon l'une ou plusieurs des revendications précédentes, comportant plusieurs condensateurs, en conception sous forme de bloc capacitif de touches pour instruments d'entrée d'installations de traitement de l'information, caractérisé en ce que les condensateurs (C1, 2) sont disposés sous forme de matrice ; et en ce que les électrodes supérieures, ou contre-électrodes (C2) des condensateurs ne sont pas directement reliées avec les conducteurs (L2) de raccordement situés dans le même plan, mais peuvent être reliés, à volonté, avec ces conducteurs au moyen de contacts (13) de pontage que l'on peut manœuvrer par des touches (figure 1f).

10. Circuit imprimé selon la revendication 9, caractérisé en ce que dans les espaces intermédiaires du dispositif à matrice de condensateurs sont prévus des moyens d'écartement (11, fig. 1f) qui s'élèvent au-dessus du plan des électrodes supérieures ou contre-électrodes (C2) des condensateurs et des rubans conducteurs correspondants (L2) ; et en ce que sur ces moyens d'écartement (11) est placé un dispositif support (12) pour les contacts mobiles (13) de pontage qui collaborent avec des électrodes supérieures ou contre-électrodes (C2) des condensateurs et avec les conducteurs (L2) de raccordement correspondants.

11. Circuit imprimé selon la revendication 10, caractérisé en ce que, comme moyen d'écartement, il est prévu une feuille d'une seule pièce (11) présentant des évidements correspondant aux condensateurs (C2) et à leur conducteur (L2) de raccordement correspondant ; et en ce que le support pour les contacts de pontage est constitué d'une feuille souple (12) qui est posée par dessus la feuille (11) d'écartement et qui présente sur sa face inférieure, dans les évidements de la feuille (11) d'écartement et en correspondance avec les électrodes supérieures ou contre-électrodes (C2) des condensateurs et les rubans conducteurs (L2) correspondants des couches (13) rapportées par métallisation et servant de contacts de pontage.

12. Procédé de fabrication d'un condensateur en couche épaisse, selon la technique du circuit imprimé, convenant pour un bloc capacitif de touches fabriqué selon la technique du circuit imprimé, ou bien d'un circuit imprimé contenant un ou plusieurs condensateurs en couche épaisse type avec des rubans conducteurs correspondants, selon une ou plusieurs des revendications précédentes, dans lequel on produit, sur une plaquette substrat ou plaquette support, l'électrode inférieure, ou électrode de masse, respective du condensateur ou des condensateurs, puis on rapporte, par le procédé de sérigraphie, un diélectrique en couche épaisse sur la ou les électrodes de masse du condensateur, puis, après durcissement du diélectrique, on rapporte la ou les contre-électrodes de condensateur dans l'alignement de la ou des électrodes de masse du condensateur, le diélectrique étant une dispersion, qui peut se rapporter par sérigraphie, de matières diélectriques de charge dans un matériau polymère qui peut durcir à températures relativement basses, caractérisé en ce que, pour obtenir, la ou les électrodes supérieures ou contre-électrodes (C2) des condensateurs et éventuellement les rubans conducteurs (L2) correspondants, on rapporte sur la première couche diélectrique (6), après son durcissement, selon le procédé de sérigraphie, et conformément au tracé désiré pour la contre-électrode, ou les contre-électrodes, des condensateurs (C2) et éventuellement pour les rubans conducteurs (12) correspondants, une seconde couche diélectrique (8) de même type qui contient en outre un catalyseur pour activer la couche pour permettre une métallisation sans passage du courant ; et en ce qu'ensuite on métallise cette seconde couche diélectrique (8) à partir d'un bain (10, figure 1e), travaillant sans passage de courant, en formant la contre-électrode, ou les contre-électrodes, des condensateurs (C2) et éventuellement les rubans conducteurs (L2) correspondants.

13. Procédé selon la revendication 12, caractérisé en ce que la dispersion, qui peut se rapporter par sérigraphie, prévue pour produire le diélectrique en couche épaisse (6) contient comme matériau polymère une ou plusieurs résines polymères du groupe résine de polyuréthanne, résine de polyester, résine époxyde, résine de mélamineformaldéhyde.

14. Procédé selon la revendication 12 ou 13, caractérisé en ce que pour obtenir la ou les électrodes inférieures ou électrodes de masse des condensateurs (C1) ainsi qu'éventuellement les rubans conducteurs (L1) correspondants, on rapporte par impression sur la plaquette substrat ou plaquette support (1) une pâte sérigraphique activée pour permettre une métallisation sans passage du courant, par le procédé sérigraphique et selon le tracé désiré pour les condensateurs et les rubans conducteurs ; et en ce qu'après durcissement, on la métallise (5) dans un bain chimique sans passage du courant, en produisant la ou les électrodes de masse des condensateurs (C1) ainsi qu'éventuellement les rubans conducteurs (L1) (figures 1a et 1b).

15. Procédé selon la revendication 12 ou 13, caractérisé en ce que l'on produit l'électrode inférieure, ou électrode de masse du condensateur, ou les électrodes de masse des condensateurs, (C1), ainsi qu'éventuellement les rubans conducteurs (L1) correspondants par le procédé d'élimination par gravure chimique sélective d'un doublage métallique de la plaquette substrat ou plaquette support.

16. Procédé selon une ou plusieurs des revendications 12 à 15, caractérisé en ce que le durcissement de la couche diélectrique ou des couches diélectriques (6, figure 1c ; 8, figure 1d) se fait à des températures situées sur la plage allant de 150 °C à 230 °C.

17. Procédé de fabrication des circuits imprimés contenant des condensateurs en couche épaisse pour un bloc capacitif de touches et les liaisons de conducteurs correspondants, caractérisé par les étapes suivantes de procédé :

a) sur une plaque substrat ou plaquette support (1), on rapporte par impression une pâte sérigraphique (2) métallisable sans passage de courant, par le procédé sérigraphique, selon le tracé désiré pour les zones formant condensateurs (3, figure 1a) et les zones formant rubans conducteurs (4) correspondants d'un plan conducteur inférieur (figure 1a) ;

b) après durcissement, on métallise dans un bain chimique travaillant sans passage de courant la pâte sérigraphique ainsi rapportée (2), en formant les électrodes inférieures ou électrodes de masse des condensateurs (C1) et les rubans conducteurs (L1) correspondants d'un plan conducteur inférieur (figure 1b) ;

c) comme étape suivante, on rapporte par impression sur la plaquette de circuit imprimé une couche diélectrique (6) qui peut durcir à des températures comprises entre 150 °C et 230 °C et qui contient une dispersion de matières diélectriques de charge dans une résine polymère (figure 1c), étant précisé que dans les zones (4, 7), situées à l'extérieur des zones formant condensateurs (3), on peut employer une couche diélectrique de plus faible constante diélectrique (figure 1c) ;

d) on fait durcir la couche diélectrique (6) à des températures situées entre 150 °C et 230 °C ;

e) sur la première couche diélectrique (6), on rapporte par impression selon le procédé sérigraphique, suivant le tracé désiré, sur les zones formant condensateurs (3, figure 1d) et éventuellement sur les zones (9) prévues pour les rubans conducteurs d'un second plan conducteur, une seconde couche diélectrique (8) qui contient un constituant catalyseur pour activer la couche pour permettre une métallisation sans passage du courant (figure 1d), étant précisé à nouveau que dans les zones situées à l'extérieur des zones formant condensateurs (3), on peut employer une couche diélectrique de constante diélectrique plus faible et ne contenant pas le constituant catalyseur ;

f) on fait durcir la seconde couche diélectrique (8) à une température située entre 150 °C et 230 °C ;

g) on métallise la seconde couche diélectrique (8) dans un bain chimique (10, figure 1e), travaillant sans passage du courant, en produisant les électrodes supérieures, ou contre-électrodes des condensateurs (C2) ainsi que les rubans conducteurs (L2) correspondants d'un second plan conducteur (figure 1e).

18. Procédé selon la revendication 17, caractérisé en ce que les couches diélectriques (6, 8, figures 1c, 1d) contiennent, dans les zones formant condensateurs (3), une ou plusieurs charges diélectriques du groupe ZnO, $Al_2O_3$, $SrTiO_3$, BaTiO ou des substances céramiques de constante diélectrique plus élevée.

19. Procédé selon la revendication 17 ou 18, caractérisé en ce que, dans les zones situées à l'extérieur des zones formant condensateurs (3), les couches diélectriques (6, 8) contiennent une ou plusieurs charges diélectriques du groupe $Al_2O_3$, MgO ou des substances céramiques de plus faible constante diélectrique.

20. Procédé selon une ou plusieurs des revendications 17 à 19, caractérisé en ce que les couches diélectriques (6, 8) contiennent les matières diélectriques de charge dispersées dans une résine polymère du groupe résine de polyuréthanne, résine de polyester, résine époxyde, résine de mélamineformaldéhyde.

21. Procédé selon une ou plusieurs des revendications 17 à 20, caractérisé en ce que la seconde couche diélectrique (8) activée pour permettre une métallisation sans passage de courant contient comme catalyseur d'activation du Pd ou un composé de Pd réductible.

Fig. 1a

Fig. 1b

Fig. 1c

Fig. 1d

Fig. 1e

Fig. 1f

Fig.2

Datenausgang

18

Decodierungsschaltung          14

Kap.
Interface          16

Kap. Keyboard
Matrix          17

Multiplexer          15